# EUROPÄISCHE PATENTSCHRIFT

(11) **EP 1 973 230 B1**
(45) Veröffentlichungstag und Bekanntmachung des Hinweises auf die Patenterteilung: **16.12.2009**
(21) Anmeldenummer: 08102710.4
(22) Anmeldetag: 18.03.2008
(51) Int. Cl.: H03K 17/16

(54) **System mit einem Schaltnetzteil**
System with a switching power supply
Système doté d'un circuit de commutation d'alimentation électrique

(30) Priorität: 21.03.2007 DE 102007013562
(43) Veröffentlichungstag der Anmeldung: 24.09.2008
(73) Patentinhaber: Continental Automotive GmbH, 30165 Hannover (DE)
(72) Erfinder: Schlösser, Theodoor Antoon Jozef, 5655 JW Eindhoven (NL)

(56) Entgegenhaltungen:
- EP-A- 1 184 961
- DE-A1- 2 815 895
- US-A- 4 188 585
- US-A- 5 416 434
- US-A- 5 629 590
- US-A1- 2004 217 748
- US-B1- 6 249 876
- US-B1- 6 341 073

## Beschreibung

Die Erfindung betrifft ein System mit einem Schaltnetzteil. Ein Schaltnetzteil wird eingesetzt zum Wandeln einer elektrischen Spannung. Schaltnetzteile finden zunehmend eine weite Verbreitung und werden beispielsweise für Computer, Beleuchtungssysteme mit Halogenlampen, Ladegeräte oder beispielsweise auch im Zusammenhang mit Radiogeräten eingesetzt. Typischerweise weisen Schaltnetzteile einen hohen Wirkungsgrad auf und können kompakt ausgebildet sein. Eine Herausforderung im Zusammenhang mit Schaltnetzteilen ist ihre elektromagnetische Verträglichkeit. So ist es beispielsweise erforderlich im Zusammenhang mit einem Einsatz des Schaltnetzteils für ein Radio eine Störung der gewünschten zu empfangenden Radiofrequenz wirkungsvoll zu vermeiden.

Aus der US 4,188,585 ist es bekannt, verschiedenen Verstärkern Gleichspannung mittels geschalteter Gleichspannungsschaltnetzteile zuzuführen. Dabei erfolgt das Schalten der Schaltnetzteile mittels einer gemeinsamen Multivibratorquelle, die eine Oszillatorfrequenz leicht höher als die natürliche Oszillatorfrequenz der Schaltnetzteile aufweist.

Aus der US 5,416,434 ist ein adaptives Taktgenerierungssystem zum Generieren eines adaptiven Taktsignals bekannt, das System umfasst eine Masteruhr, einen programmierbaren Pulsgenerator und einen Funktionsblock. Der programmierbare Pulsgenerator ist dazu ausgebildet, eine Frequenz von Pulsen zu erzeugen, wobei jeder High-Puls eine vorgegebene Breite hat und gefolgt ist durch einen Low-Puls, dessen Breite N Mastertaktperioden breit ist.

Aus der US 5,629,590 ist es bekannt, einen Mikrocontroller derart auszubilden, dass er Ansteuersignale für einen Antriebsmotor variabler Geschwindigkeit erzeugt.

Die Aufgabe, die der Erfindung zugrunde liegt, ist ein System mit einem Schaltnetzteil zu schaffen, das einfach ist und einen störungsarmen Betrieb ermöglicht.

Die Aufgabe wird gelöst durch die Merkmale des Anspruchs 1. Vorteilhafte Ausgestaltungen der Erfindung sind in den Unteransprüchen gekennzeichnet.

Die Erfindung zeichnet sich aus durch ein System mit einem Empfänger, einem Schaltnetzteil und einem Mikrocontroller. Der Empfänger ist ausgebildet zum Empfangen von hochfrequenten Signalen über eine ihm zugeordnete Antenne. Das Schaltnetzteil hat einen Schalter als Stellglied zum Beeinflussen einer Ausgangsspannung des Schaltnetzteils, dessen Schaltstellung abhängt von einem Steuersignal. Das Schaltnetzteil umfasst ferner eine Steuereinheit, die ausgebildet ist zum Erzeugen des Schaltsteuersignals abhängig von einem Taktsignal, das über einen Taktsignaleingang des Schaltnetzteils dem Schaltnetzteil extern zuführbar ist. Auf diese Weise kann einfach über den Taktsignaleingang ein Taktsignal beliebig gewählter Taktfrequenz zugeführt werden und so ein einfach den jeweiligen aktuellen Anforderungen angepasstes Vermeiden des Abstrahlens elektromagnetischer Strahlung in vorgegebenen oder zumindest einem vorgegebenen Frequenzband erreicht werden.

Der Mikrocontroller ist ausgebildet zum Vorgeben einer Abstimmfrequenz für den Empfänger, wobei der Mikrocontroller einen Taktgenerator umfasst, der ausgebildet ist zum Erzeugen des Taktsignals für das Schaltnetzteil abhängig von der Abstimmfrequenz. Auf diese Weise kann der ohnehin in dem Mikrocontroller regelmäßig vorhandene Taktgenerator, der ausgebildet ist zum Erzeugen eines intern in dem Mikrocontroller genutzten Mikrocontroller-Taktsignals mit einem geringen Anpassungsaufwand eingesetzt werden zum Erzeugen des Taktsignals für das Schaltnetzteil. Ferner kann so einfach sehr präzise die Taktfrequenz des Taktsignals günstig in Bezug auf die jeweils aktuell eingestellte Abstimmfrequenz vorgegeben werden und zwar derart, dass ein aktuell über die Antenne zu empfangen beabsichtigtes Frequenzband nicht oder nur unwesentlich durch elektromagnetische Störstrahlung des Schaltnetzteils beeinflusst ist. In diesem Zusammenhang kann so jeweils die Taktfrequenz des Taktsignals geeignet in einem Frequenzband vorgegeben werden, dessen Oberwellen außerhalb des jeweiligen gerade zum Empfang gewünschten Frequenzbandes durch die Antenne liegen.

Gemäß einer vorteilhaften Ausgestaltung des zweiten Aspekts umfasst der Taktgenerator einen Zufallsgenerator, der so in dem Taktgenerator wirkend ausgebildet ist, dass eine vorgegebene Frequenzspreizung des Taktsignals erfolgt, auch bei gleich bleibender Abstimmfrequenz. Auf diese Weise können Störeinflüsse besonders wirkungsvoll sehr gering gehalten werden.

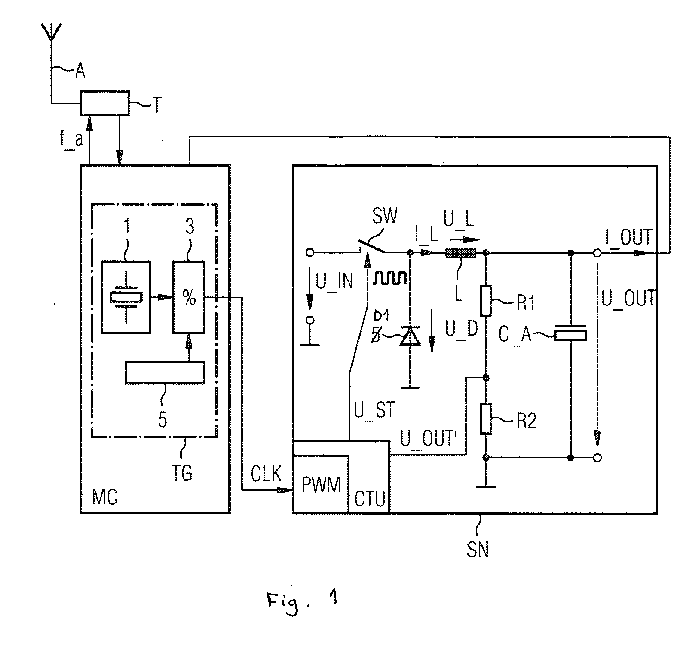

Ausführungsbeispiele der Erfindung sind im Folgenden anhand der schematischen Zeichnung in der einzigen Figur 1 näher erläutert.

Die einzige Figur zeigt ein System, das einen Mikrocontroller MC und ein Schaltnetzteil SN umfasst. Dem Mikrocontroller ist ein Empfänger T zugeordnet, dem wiederum eine Antenne A zum Empfangen hochfrequenter Signale, insbesondere in den Frequenzbereichen von Rundfunkwellen, zugeordnet ist. Der Empfänger ist beispielsweise in diesem Zusammenhang ausgebildet als Überlagerungsempfänger, der auch als Superheterodynempfänger bezeichnet wird. Dazu umfasst der Empfänger bevorzugt eine Hochfrequenz-Verstärkerstufe, die ausgebildet ist, zur Frequenzvorselektion und zur entsprechenden Verstärkung. Der Hochfrequenz-Verstärkerstufe ist eine Mischstufe nachgeschaltet, die ausgebildet ist zum Mischen des Ausgangssignals der Hochfrequenz-Verstärkerstufe mit einem Abstimmfrequenzsignal, dessen Frequenz der Abstimmfrequenz f_a entspricht. Durch diesen Mischvorgang werden ausgangsseitig eine Reihe neuer Frequenzen erzeugt, die neben den Originalfrequenzen auch eine Summe und eine Differenz der Frequenzen der jeweils gemischten Signale enthalten.

Ferner ist ein Zwischenfrequenzfilter vorgesehen, der dazu ausgebildet ist, ein schmales Frequenzband um eine Zwischenfrequenz herum fast ungehindert zu passieren und alle anderen Frequenzbereiche stark zu dämpfen. Dabei ist die Abstimmfrequenz f_a geeignet auf die Zwischenfrequenz abgestimmt. Dem Zwischenfrequenzfilter ist ein Zwischenfrequenzverstärker nachgeschaltet, der das gefilterte Frequenzgemisch für die weitere Verarbeitung verstärkt. Dem Zwischenfrequenzverstärker sind ein Demodulator und ein Niederfrequenzverstärker nachgeschaltet, die beispielsweise auch in dem Mikrocontroller ausgebildet sein können.

Der Mikrocontroller ist dazu ausgebildet, dem Empfänger T die jeweilige aktuelle Abstimmfrequenz f_a vorzugeben. Dazu kann beispielsweise der Mikrocontroller mit einer geeigneten Benutzerschnittstelle gekoppelt sein, über die ein Benutzer beispielsweise auf geeignete Art und Weise die gerade gewünschte Empfangsfrequenz vorgeben kann, die mittels des Empfängers empfangen werden soll, so beispielsweise die UKW-Frequenz 98,5 kHz oder 100 kHz oder dergleichen. Der Mikrocontroller weist einen Speicher auf, in dem Programme und/oder Daten gespeichert sein können und ist diesbezüglich dazu ausgebildet, abhängig von der ihm vorgegebenen gewünschten Empfangsfrequenz die geeignete zugeordnete Abstimmfrequenz f_a zu ermitteln und dem Empfänger T entsprechend vorzugeben. Der Mikrocontroller kann gegebenenfalls auch Komponenten umfassen zum Verstärken des Ausgangssignals des Demodulators des Überlagerungsempfängers und zum anschließenden Ausgeben an einen oder mehrere Lautsprecher.

Das Schaltnetzteil SN ist ausgebildet zum Erzeugen einer vorgegebenen Ausgangsspannung U OUT zum Versorgen des Mikrocontrollers MC und bevorzugt auch des Empfängers T. Das Schaltnetzteil umfasst einen Schalter SW als Stellglied zum Beeinflussen seiner Ausgangsspannung U_OUT. Der Schalter ist beispielsweise als Schalttransistor ausgebildet. Die Schaltstellung des Schalters SW wird maßgeblich bestimmt durch ein Schaltsteuersignal U_ST. Das Schaltnetzteil SN umfasst ferner eine Steuereinheit CTU, die ausgebildet ist zum Erzeugen des Schaltsteuersignals U_ST. Das Schaltsteuersignal U_ST weist während des Betriebs des Schaltnetzteils SN eine hohe Frequenz auf, die beispielsweise zwischen 20 und etwa 300 kHz liegen kann.

Das Schaltnetzteil kann ein primär oder ein sekundär getaktetes Schaltnetzteil sein. Es kann beispielsweise einen Sperrwandler, einen Durchflusswandler oder einen Resonanzwandler umfassen. So kann es grundsätzlich beispielsweise als Abwärtswandler, Aufwärtswandler, invertierender Wandler, Sperrwandler, Eintakt-Durchflusswandler, Halbbrücken-Durchflusswandler, Vollbrücken-Gegentaktwandler, Halbbrücken-Gegentaktwandler, Gegentaktwandler mit Paralleleinspeisung oder auch als Gegentakt-Resonanzwandler ausgebildet sein.

Beispielhaft ist in der Figur eine Ausbildung des Schaltnetzteils SN mit einem Abwärtswandler dargestellt. Es umfasst eine Diode D1. Die Anode der Diode D1 ist mit einem Bezugspotential direkt gekoppelt, das beispielsweise ein Massepotential sein kann. Der Schalter SW ist in Reihe geschaltet mit einer Induktivität L, die beispielsweise als Drosselspule ausgebildet sein kann. Die über der Induktivität L abfallende Spannung wird mit U_L bezeichnet. Die über der Diode D1 entgegen ihrer Durchlassrichtung abfallende Spannung wird als U_D bezeichnet. Eingangsseitig des Schalters ist dieser mit einer Eingangsspannung U_IN beaufschlagt, die beispielsweise durch Gleichrichten einer vorgegebenen Netzspannung erzeugt wird. Ferner ist ein Kondensator C_A elektrisch zwischen der Induktivität L und dem Bezugspotential angeordnet und bildet im Zusammenwirken mit der Induktivität L einen Tiefpassfilter zum Glätten der Ausgangsspannung U_OUT. Die Ausgangsspannung U_OUT und der korrespondierende Ausgangsstrom I_OUT wird ausgangsseitig des Schaltnetzteils SN zur Verfügung gestellt und zwar beispielsweise für den Mikrocontroller, der eingangsseitig mit dem Ausgang des Schaltnetzteils elektrisch leitend gekoppelt ist.

Das Schaltnetzteil weist ferner einen hochohmigen Spannungsteiler auf, der gebildet ist durch Widerstände R1 und R2, wobei elektrisch zwischen den Widerständen R1 und R2 ein Abgriff vorgesehen ist, der elektrisch leitend mit der Steuereinheit CTU gekoppelt ist und an den eine im Vergleich zu der Ausgangsspannung U_OUT proportional reduzierte Ausgangsspannung U_OUT' abgegriffen wird. Unter der vereinfachenden Annahme, dass während einer jeweiligen Einschaltphase des Schalters SW und der Diode D1 an diesen keine Spannung abfällt, ist die Funktionsweise des Schaltnetzteils wie folgt.

Während der Einschaltphase des Schalters SW ist die über der Diode D1 abfallende Diodenspannung U_D gleich der Eingangsspannung U_IN. Dies hat einen Anstieg des in der Induktivität L fließenden Stroms I_L zur Folge. In der jeweiligen auf die Einschaltphase des Schalters folgenden Ausschaltphase wird dann die Diode D1 in Durchlassrichtung leitend und sorgt für eine weitere Stromzufuhr zu der Induktivität L, wobei sich der Strom durch die Induktivität L in dieser Phase verringert. Der Kondensator C_A bildet im Zusammenwirken mit der Spule L einen Tiefpass und glättet so die Ausgangsspannung U_OUT. Die Steuereinheit CTU ist dazu ausgebildet, das Schaltsteuersignal U_ST zu erzeugen. Dazu umfasst sie bevorzugt einen Pulsweitenmodulator PWM, dem ein Taktsignal CLK eingangsseitig des Schaltnetzteils zugeführt wird und zwar von dem Mikrocontroller MC. In einer besonders einfachen Ausführungsform kann mittels des Pulsweitenmodulators das Schaltsteuersignal U_ST lediglich mit einer einzigen vorgegebenen Pulsbreite erzeugt werden. Bevorzugt wird jedoch durch das Taktsignal CLK lediglich die Taktfrequenz des Schaltsteuersignals U_ST vorgegeben und die jeweilige Pulsbreite mittels eines Reglers abhängig von der reduzierten Ausgangsspannung U_OUT' ermittelt. Dazu bildet der Regler bevorzugt eine Regeldifferenz aus einer vorgegebenen Referenzspannung und der reduzierten Ausgangsspannung U_OUT' und ist vorzugsweise als Regler mit einem Integralanteil ausgebildet. Abhängig von dem Ausgangssignal des Reglers wird dann die jeweilige Pulsbreite des Schaltsteuersignals U_ST ermittelt. Das Taktsignal CLK kann verschiedene im Zusammenhang mit Taktsignalen bekannte Signalformen aufweisen, so kann es rechteckförmig oder beispielsweise auch dreieckförmig ausgebildet sein.

Zum Erzeugen des Taktsignals CLK ist in dem Mikrocontroller MC ein Taktgenerator TG vorgesehen. Der Taktgenerator TG umfasst einen Quarzoszillator 1, der sich grundsätzlich durch eine besonders hohe Frequenzgenauigkeit auszeichnet und regelmäßig in einem Mikrocontroller eingesetzt ist. Darüber hinaus weist der Taktgenerator TG einen Teiler 3 auf, der ausgebildet ist zum Verändern, also insbesondere Verringern, der Frequenz des von dem Quarzoszillator 1 erzeugten Signals und an dessen Ausgang dann das Taktsignal CLK erzeugt wird. Darüber hinaus kann bevorzugt auch ein Zufallsgenerator 5 für den Teiler 3 vorgesehen sein, der dazu ausgebildet ist, eine vorgegebene Frequenzspreizung des Taktsignals CLK zu bewirken. Der Mikrocontroller ist dazu ausgebildet, abhängig von der aktuell eingestellten Abstimmfrequenz f_a dem Teiler 3 ein jeweils zu der Abstimmfrequenz f_a zugeordnetes Teilerverhältnis vorzugeben, das dann die Taktfrequenz des Taktsignals CLK maßgeblich beeinflusst.

Mittels des Zufallsgenerators 5 erfolgt eine entsprechende Frequenzspreizung des Taktsignals CLK auch bei gleich bleibender Abstimmfrequenz f_a, was sich besonders vorteilhaft auf die Störsicherheit des Schaltnetzteils SN im Hinblick auf Störungen beim Empfang der gewünschten Frequenz durch den Empfänger T auswirkt. Die durch den Zufallsgenerator 5 bewirkte Frequenzspreizung kann beispielsweise ein Band von bis zu zirka 100 kHz umfassen. Die Taktfrequenz und gegebenenfalls auch die Frequenzspreizung des Taktsignals CLK wird bezogen auf die Abstimmfrequenz f_a durch den Mikrocontroller MC so vorgegeben, dass insbesondere die Grundschwingung und Oberwellen der durch die Taktfrequenz des Schaltsteuersignals U_ST hervorgerufenen elektromagnetischen Strahlung sich in möglichst geringem Maße negativ auf die jeweiligen gerade gewünschten zu empfangenden Frequenzen auswirkt. Auf diese Weise kann somit die in dem Mikrocontroller MC ohnehin vorhandene Information über die aktuelle Abstimmfrequenz f_a mit geringstmöglichen schaltungstechnischem Zusatzaufwand genutzt werden, um die Taktfrequenz des Taktsignals CLK für das Schaltnetzteil SN geeignet vorzugeben.

## Patentansprüche

1. System mit einem Empfänger (T), der ausgebildet ist zum Empfangen von hochfrequenten Signalen über eine ihm zugeordnete Antenne (A), mit einem Schaltnetzteil mit einem Schalter (SW) als Stellglied zum Beeinflussen einer Ausgangsspannung (U_OUT) des Schaltnetzteils (SN), dessen Schaltstellung abhängt von einem Schaltsteuersignal (U_ST), und mit einer Steuereinheit (CTU), die ausgebildet ist zum Erzeugen des Schaltsteuersignals (U_ST) abhängig von einem Taktsignal (CLK), das über einen Taktsignaleingang des Schaltnetzteils (SN) dem Schaltnetzteil (SN) extern zuführbar ist, und mit einem Mikrocontroller (MC), der ausgebildet ist zum Vorgeben einer Abstimmfrequenz (f_a) für den Empfänger (T), wobei der Mikrocontroller (MC) einen Taktgenerator (TG) umfasst, der ausgebildet ist zum Erzeugen des Taktsignals (CLK) für das Schaltnetzteil (SN) abhängig von der Abstimmfrequenz (f_a).

2. System nach Anspruch 1, bei dem der Taktgenerator (TG) einen Zufallsgenerator umfasst, der so in dem Taktgenerator (TG) wirkt und ausgebildet ist, dass eine Frequenzspreizung des Taktsignals erfolgt.

## Claims

1. System having a receiver (T) which is designed to receive radio frequency signals via an antenna (A) which is assigned to them, having a switched-mode power supply with a switch (SW) as an actuating element for influencing an output voltage (U_OUT) of the switched-mode power supply (SN), the switched position of which depends on a switching control signal (U_ST), and having a control unit (CTU) which is designed to generate the switching control signal (U_ST) as a function of a clock signal (CLK) which can be fed externally to the switched-mode power supply (SN) via a clock signal input of the switched-mode power supply (SN), and having a microcontroller (MC) which is designed to predefine a tuning frequency (f_a) for the receiver (T), wherein the microcontroller (MC) comprises a clock generator (TG) which is designed to generate the clock signal (CLK) for the switched-mode power supply (SN) as a function of the tuning frequency (f_a).

2. System according to Claim 1, in which the clock generator (TG) comprises a random generator which acts in the clock generator (TG) in such a way, and is designed in such a way, that a frequency spread of the clock signal is produced.

## Revendications

1. Système comportant un récepteur (T), configuré pour recevoir des signaux haute fréquence à travers une antenne (A) qui lui est affectée, une alimentation secteur comportant un commutateur (SW) agissant comme élément de commande permettant d'influencer une tension de sortie (U_OUT) de l'alimentation secteur (SN) et dont la position commutée est commandée par un signal de commande (U_ST), une unité de commande (CTU) conçue pour générer le signal de commande (U_ST) en fonction d'un signal d'horloge (CLK), lequel peut être appliqué à l'alimentation secteur (SN) à partir de l'extérieur par l'intermédiaire d'une entrée du signal d'horloge de l'alimentation secteur, et un microcontrôleur (MC), qui est conçu pour imposer au récepteur (T) une fréquence d'accord (f_a), où le microcontrôleur (MC) comprend un générateur d'horloge (TG), lequel est conçu pour générer le signal d'horloge (CLK) pour l'alimentation secteur (SN) en fonction de à fréquence d'accord (f_a).

2. Système selon la revendication 1, dans lequel le générateur d'horloge (TG) comprend un générateur de nombres aléatoires qui agit dans le générateur d'horloge (TG) et est conçu de manière telle qu'il se produit un étalement de la fréquence du signal d'horloge.
